# EUROPEAN PATENT APPLICATION

(11) **EP 2 903 113 A1**
(43) Date of publication of application: **05.08.2015**
(21) Application number: 14158448.2
(22) Date of filing: 07.03.2014
(51) Int. Cl.: H02H 9/04, H02H 9/06

(54) **Surge protection circuit**

(30) Priority: 31.01.2014 CN 201420058044 U
(71) Applicant: Beijing Tonlier Energy Technology Co., Ltd., Economic-Technological Development Area Daxing District Beijing 101111 (CN)
(72) Inventor: Wang, Zhen, 101111 Beijing (CN); Chen, Yonghuan, 101111 Beijing (CN)
(74) Representative: Petraz, Gilberto Luigi

(57) **Abstract**

The present invention discloses a surge protection circuit. The surge protection circuit is formed by serially connecting a piezoresistor, a discharge tube and a differential mode (DM) inductor. The present invention fully utilizes characteristics of the DM inductor, effectively suppresses electromagnetic interference, and can also effectively avoid damage caused to a surge protection element by over-voltage and over-current shocks, reduce a residual voltage, and prolong the service life of a related electronic product.

## Description

### BACKGROUND

### Technical Field

The present invention relates to a surge protection circuit, and more particularly, to a surge protection circuit implemented based on a differential mode (DM) inductor, and a light-emitting diode (LED) driving power supply using the circuit.

### Related Art

Lightning discharge is a common gas discharge phenomenon, which can generate a high-frequency peak surge voltage within an extremely short period of time, and significantly influences the reliability of a switching power supply, especially an LED driving power supply, connected to an alternating current (AC) network. However, the most common damage of the lightning is not caused by direct lightning, but is caused by an inductive current surge in the driving power supply when the lightning occurs. With the high-speed development of the LED lighting technology, there are increasingly high requirements on performance of the LED driving power supply; however, due to highly integration inside the power supply and low rated voltages of circuit elements, capabilities of the device for resisting overvoltage and overcurrent are reduced, and the endurance to lightning is reduced. Surge protection has become a necessary performance of a driving power supply.

A surge protection circuit suppresses a surge voltage and an impulse voltage generated at an instant by a power supplying device, and can be conducted within an extremely short period of time for shunting, thereby preventing other devices in the circuit from being damaged by the surge voltage and the impulse voltage, so as to protect the devices. The surge protection circuit, as a protection circuit, is very important for subsequent working circuits. However, in an actual application, the surge protection circuit is often damaged because of multiple surge shocks, so that the service life of the whole LED driving power supply is shortened.

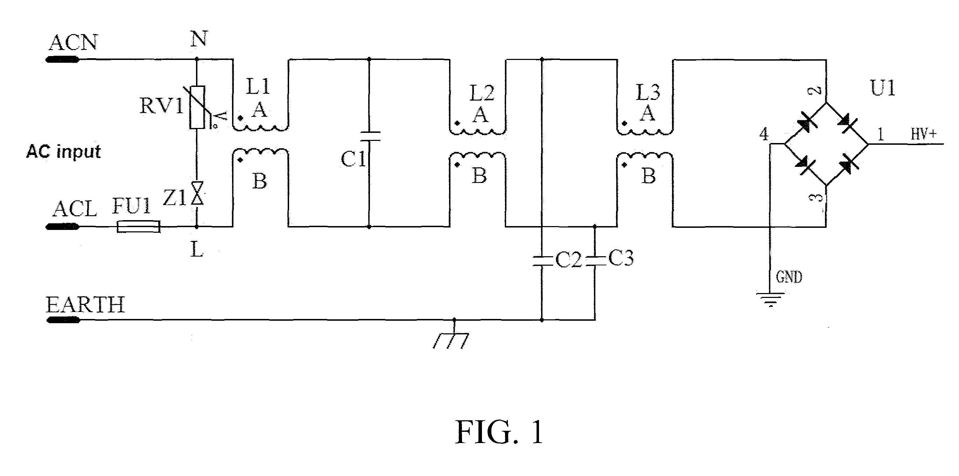

In the prior art, a surge protection method is generally connecting a piezoresistor between a neutral wire and a live wire or serially connecting a piezoresistor and a discharge tube (to serve as a surge protection element). For example, in Chinese Patent Application No. 201010144754.6, an LED street lamp driving circuit capable of automatically adjusting output brightness is disclosed, which includes an input surge protection and electromagnetic interference suppression circuit, a single-tube flyback switching power supply circuit having a power factor correction function, an ambient brightness detection circuit, a chip temperature detection circuit, a perpetual calendar chip and a peripheral circuit thereof. In the input surge protection circuit in the LED street lamp driving circuit, a piezoresistor is directly connected in parallel between a neutral wire and a live wire. For another example, in FIG. 1, the surge protection circuit includes a piezoresistor RV1 and a gas discharge tube Z1 between a neutral wire ACN and a live wire ACL. During implementation of the present invention, the inventor finds that the prior art at least has the following problems. In an actual application of a surge protection circuit, a surge protection element is generally close to an input end of AC, and a piezoresistor and a protected circuit are struck by multiple surges, so that the elements are easily damaged, and the service life of a related electronic product is significantly shortened.

### SUMMARY

According to the defects of the prior art, a technical problem to be solved by the present invention is providing a surge protection circuit and a light-emitting diode (LED) driving power supply using the circuit.

In order to achieve the objectives, the present invention adopts the following technical solutions:
A surge protection circuit, wherein the surge protection circuit is formed by serially connecting a piezoresistor, a discharge tube and a differential mode (DM) inductor.

Preferably, the DM inductor is implemented by a half inductor of a common mode (CM) inductor in an electromagnetic interference (EMI) filter circuit.

Preferably, when the CM inductor in the EMI filter circuit includes multiple stages of CM inductors, the DM inductor is a half inductor of a part or all of the CM inductors.

In addition, the present invention further provides an LED driving power supply, which uses the surge protection circuit.

In the present invention, a DM inductor is connected in a surge protection circuit, so as to fully utilize characteristics of the DM inductor; the EMI is effectively suppressed, and the damage caused to the surge protection element by overvoltage and overcurrent shocks may also be effectively avoided, so as to reduce residual voltage and prolong the service life of a related electronic protect.

### BRIEF DESCRIPTION OF THE DRAWINGS

The disclosure will become more fully understood from the detailed description given herein below for illustration only, and thus are not limitative of the disclosure, and wherein:
FIG. 1 is a principle diagram of a typical surge protection circuit in the prior art;
FIG. 2 is a principle diagram of a surge protection circuit according to a first embodiment of the present invention;
FIG. 3 is a principle diagram of a variation of the surge protection circuit on the basis of the first embodiment;
FIG. 4 is a principle diagram of a surge protection circuit according to a second embodiment of the present invention;
FIG. 5 is a principle diagram of a variation of the surge protection circuit on the basis of the second embodiment;
FIG. 6 is a principle diagram of a surge protection circuit according to a third embodiment of the present invention
FIG. 7 is a principle diagram of a variation of the surge protection circuit on the basis of the third embodiment; and
FIG. 8 is a principle diagram of another variation of the surge protection circuit on the basis of the third embodiment.

### DETAILED DESCRIPTION

In the present invention, a differential mode (DM) inductor is connected in a surge protection circuit. When surge occurs, a piezoresistor, a discharge tube and a DM inductor are serially connected to form a surge protection circuit. Based on characteristics of an inductor element, current in the whole protection circuit does not change suddenly, thereby reducing shock to a device caused by a surge current. Moreover, inductive reactance generated by the inductor element may reduce a voltage applied to the piezoresistor and the discharge tube. The surge protection circuit, through the DM inductor connected therein, may effectively avoid damage to the piezoresistor and the discharge tube caused by overvoltage and overcurrent shocks, and may also reduce a residual voltage, and prolong the service life of a related electronic product. It should be noted that, a common mode (CM) inductor may also be applied to the present invention when being used as the DM inductor, which is further described in the following.

### First embodiment

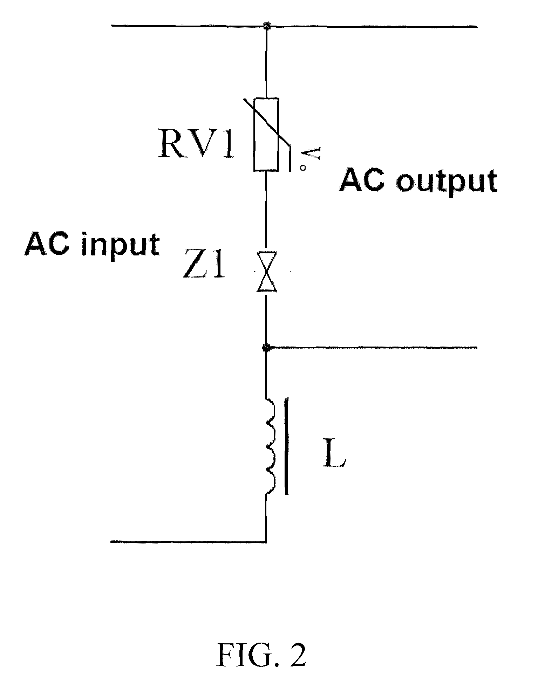

The surge protection circuit provided by the present invention includes a piezoresistor, a discharge tube and a DM inductor. It should be noted that, the discharge tube may also be replaced by a short-circuit wire. The discharge tube preferably adopts a gas discharge tube. Referring to FIG. 2, one of alternating current (AC) input ends is serially connected to the DM inductor L. a circuit formed by serially connecting the piezoresistor RV1 and the gas discharge tube Z1 is connected in parallel between AC output ends. When the piezoresistor is applied for protection of an AC power supply system, because of a large parasitic capacitance, leakage current often occurs in a normal operation state. The leakage current often affects normal operation of another circuit. After the piezoresistor is serially connected to the discharge tube, because the parasitic capacitance of the discharge tube is very small, the total capacitance of the whole series circuit is reduced. The gas discharge tube here functions as a switch. When no transient overcurrent effect occurs, the gas discharge tube can isolate the piezoresistor from other circuit parts, so that nearly no leakage current exists in the piezoresistor. During a surge shock period, the gas discharge tube is broken down, and discharges rapidly to be conducted, so that the piezoresistor enables a voltage of the circuit to be clamped in a safe range for subsequent working of the circuit. In the present invention, the DM inductor is introduced into the surge protection circuit, a differential signal of the surge, after passing through the DM inductor, implements voltage division under effect of inductive reactance, and meanwhile suppresses sudden change of the current in the circuit. Because of the inductor, excessive current in the piezoresistor and the gas discharge tube may be effectively suppressed, thereby avoiding the damage caused to the surge protection element by the overcurrent of the surge, and meanwhile reducing the residual voltage.

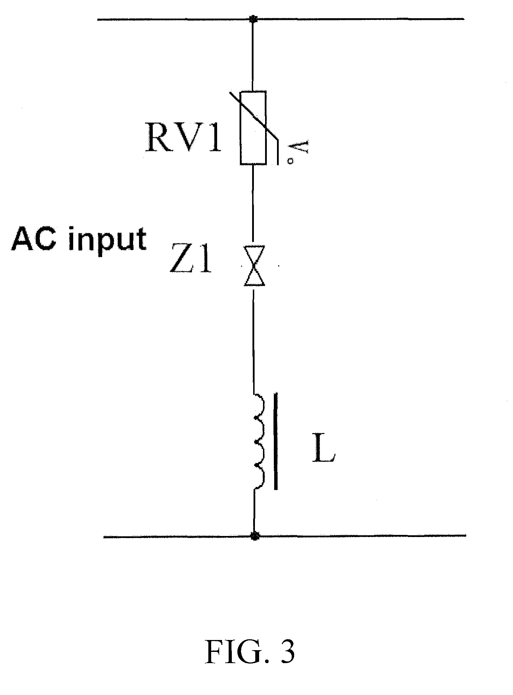

It can be seen from the first embodiment that, the connection position of the DM inductor may be adjusted. For example, each of the AC input ends is serially connected to a DM inductor. The piezoresistor, the gas discharge tube and the two DM inductors form a surge protection circuit. For another example, in FIG. 3, a series circuit formed by the piezoresistor, the gas discharge tube and the DM inductor is connected in parallel between AC input ends. When a switching power supply works normally, the series circuit formed by the DM inductor, the piezoresistor and the gas discharge tube is isolated from another circuit, and does not work. Only when the surge strikes, the surge protection circuit can discharge the current, so as to protect other circuits from being struck by the surge. In addition, the number of the DM inductors in the surge protection circuit may be adjusted. For a surge protection circuit including multiple DM inductors, detailed description thereof is not provided herein. It should be noted that, in the surge protection circuit, a larger number of serially connected DM inductors results in a more obvious anti-surge effect.

### Second embodiment

A surge protection circuit in this embodiment is implemented in combination with an electromagnetic interference (EMI) filter circuit. In FIG. 1, a conventional switching power supply circuit includes a surge protection circuit, an EMI filter circuit and a rectifier circuit. The surge protection circuit is connected in parallel between a neutral wire ACN and a live wire ACL. After being connected in parallel to the surge protection circuit, the neutral wire ACN and the live wire ACL are then connected to the EMI filter circuit. The EMI filter circuit is connected to the rectifier circuit. When a surge occurs, the gas discharge tube is broken down and discharges to be conducted, and the piezoresistor clamps a voltage between the neutral wire and the live wire to ensure subsequent normal working of the circuit. However, the surge protection element may be damaged after multiple shocks of overvoltage and overcurrent, so that the service life of the whole switching power supply is significantly shortened. The surge protection circuit provided in this embodiment is an improvement for the conventional switching power supply circuit, no new element is added, but a half inductor of a common mode (CM) inductor in the EMI filter circuit is used as a differential mode (DM) inductor, so as to reduce the shock of the surge. Therefore, this embodiment implements effective combination of the surge protection circuit and the EMI filter circuit.

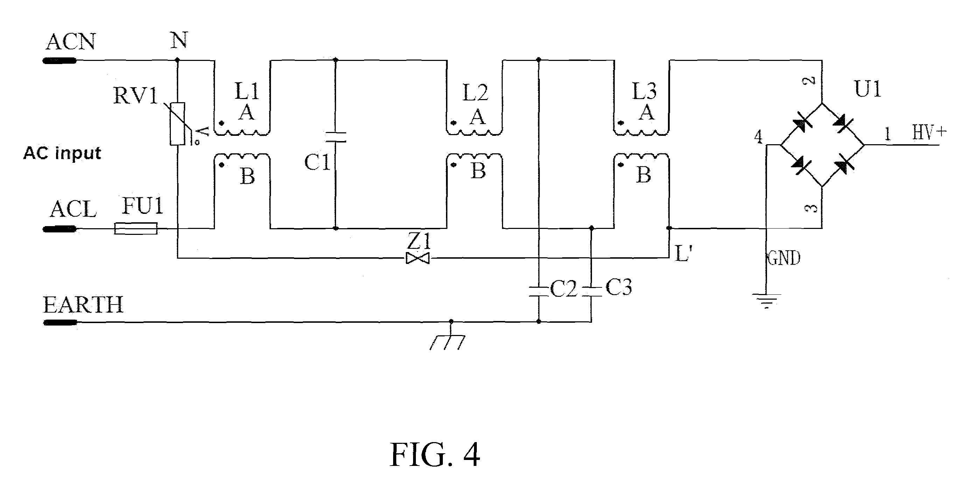

Referring to FIG. 4, the EMI filter circuit in this embodiment has three stages of CM inductors, namely, L1, L2, and L3, where L1 is used to reduce radiation, and L2 and L3 are used to suppress conductivity. Two input ends of the first-stage CM inductor L1 are respectively connected to the neutral wire ACN and the live wire ACL (a fuse FU1 is connected there-between), two output ends thereof are serially connected to the second-stage CM inductor, and an X capacitor C1 is connected in parallel between the two output ends. Two output ends of the second-stage CM inductor L2 are connected to input ends of the third-stage CM inductor L3, and are also connected to a ground wire through Y capacitors C2 and C3. Output ends of the third-stage CM inductor L3 are connected to a rectifier circuit U1. Two half inductors of each CM inductor are marked respectively as A and B. The half inductors A, namely, L1A, L2A and L3A, are connected to the neutral wire. Correspondingly, the half inductors B, namely, L1B, L2B and L3B, are connected to the live wire. In this embodiment, the surge protection circuit includes a piezoresistor RV1, a gas discharge tube Z1 and a half inductor B in the CM inductor. One end N of a series circuit formed by the piezoresistor RV1 and the gas discharge tube Z1 is connected to an input end (neutral wire) of the first-stage CM inductor L1A, and the other end L' is connected to an output end of the half inductor L3B of the third-stage CM inductor. In this embodiment, values of the CM inductors and the capacitors are not limited. When an AC input voltage range is not greater than 305 V, the model of the piezoresistor is preferably any one of 331KD14, 331KD10, 361KD10, and 361KD14. The model of the gas discharge tube is preferably 2RL470L-5. A working principle of this embodiment is described in detail in the following.

When the switching power supply circuit works normally, the piezoresistor and the gas discharge tube are not conducted. The CM inductors L1, L2 and L3 in the EMI filter circuit cooperate with the capacitors C1, C2 and C3, so as to provide strong filtering for AC conducted transient and RF noise. Because of a switching action of the gas discharge tube, when there is no transient overvoltage, the surge protection circuit is isolated from the EMI filter circuit and the rectifier circuit. When a peak voltage of a surge signal is greater than 470 V, the gas discharge tube Z1 is broken down instantaneously. At this time, the half inductors L1B, L2B and L3B of the CM inductors are serially connected to the piezoresistor RV1 and the gas discharge tube Z1 to form a loop. Because the peak voltage is greater than a threshold voltage of the piezoresistor, based on the characteristics of the piezoresistor, the voltage of the surge protection circuit is pulled down rapidly from an over-high voltage to 331 V (for the piezoresistor of the model 331KD14 or 331KD10) or 361 V (for the piezoresistor of the model 361KD10 or 361KD14), thereby preventing a later stage EMI filter circuit and the rectifier circuit from being damaged due to the overvoltage. A differential signal of the surge passes through the half inductors L1B, L2B and L3B of the CM inductors, and based on the inductive reactance function of the half inductors L1B, L2B and L3B serving as the DM inductor, voltage division of the piezoresistor and the gas discharge tube is implemented, thereby reducing a residual voltage and the shock of an over-high voltage to the elements. Moreover, based on the characteristic of current in the inductor, sudden change of the current in the circuit is effectively suppressed, thereby reducing a surge current applied to the piezoresistor RV1 and the gas discharge tube Z1. After the overvoltage surge disappears, when a power supply voltage exceeds a zero point, the gas discharge tube rapidly returns to a non-conducted high-resistance stage, thereby ensuring normal working of the EMI filter circuit and the rectifier circuit. For a medium stress scenario having a long duration, when the gas discharge tube is triggered, conductor resistance acts in combination with a current-limiting action of L1B, L2B and L3B, and overcurrent may be effectively prevented from passing through the discharge tube and the piezoresistor, thereby effectively improving the service life of the switching power supply.

The surge protection circuit in this embodiment implements the surge protection function by fully utilizing the CM inductors L1, L2 and L3 in the EMI filter circuit of the switching power supply, as well as the piezoresistor RV1 and the gas discharge tube Z1. During normal working, the CM inductors cooperate with capacitors to serve as a filter circuit. During surge, the half inductor in the CM inductor serves as a DM inductor to be connected into the surge protection circuit, thereby implementing combination of the surge protection circuit and the EMI filter circuit. Because the piezoresistor and the gas discharge tube are bi-directionally conducted, connection relationships between the piezoresistor, the gas discharge tube and the neutral wire and the live wire may be exchanged.

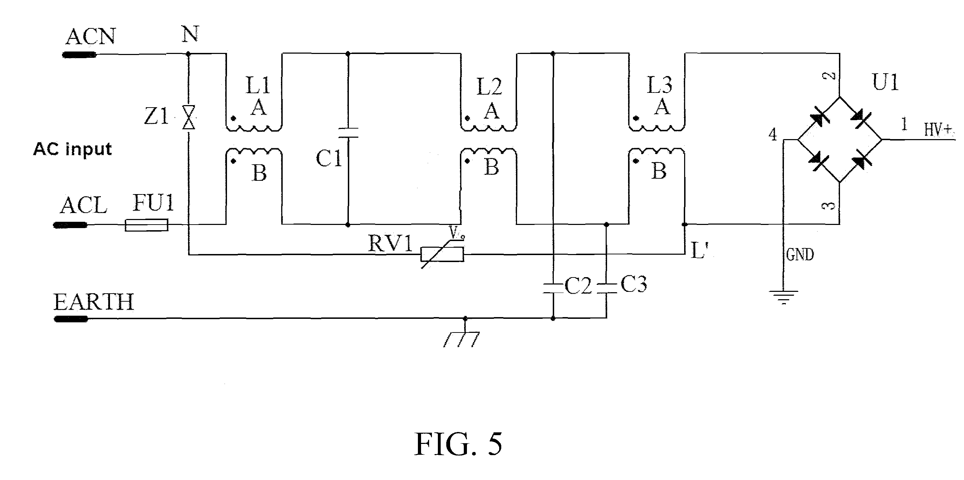

Referring to a variation shown in FIG. 5, positions of the piezoresistor and the gas discharge tube are exchanged, working principles thereof may be obtained with reference to the second embodiment, and are not repeated herein.

### Third embodiment

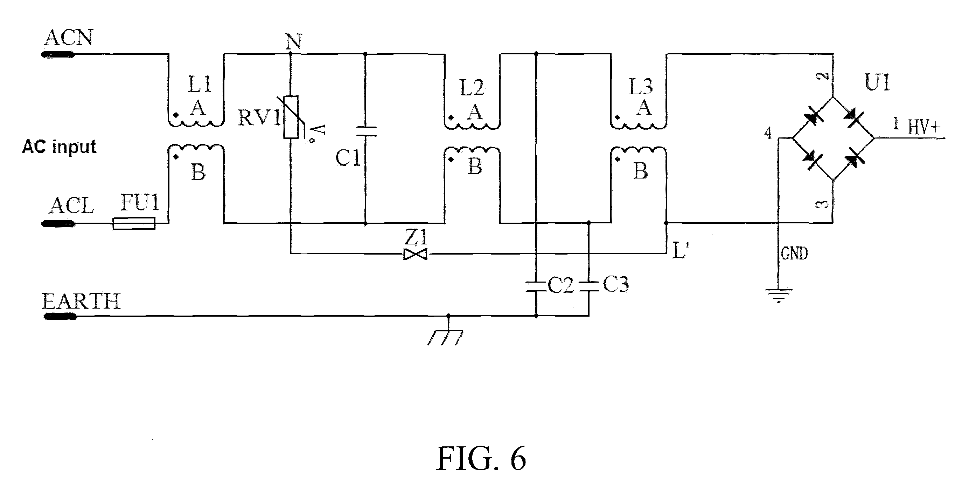

Referring to FIG. 6, this embodiment is a variation based on the second embodiment, where connection manners of an electromagnetic interference (EMI) filter circuit and a rectifier circuit may be obtained with reference to the second embodiment. A difference between this embodiment and the second embodiment lies in connection positions of a piezoresistor, a gas discharge tube, and the EMI filter circuit. In this embodiment, only half inductors of two stages of common mode (CM) inductors are used as a differential mode (DM) inductor. One end N of a series circuit formed by the gas discharge tube and the piezoresistor is connected to an output end of a first-stage CM inductor L1A, and the other end L' is connected to an output end of a third-stage CM inductor L3B.

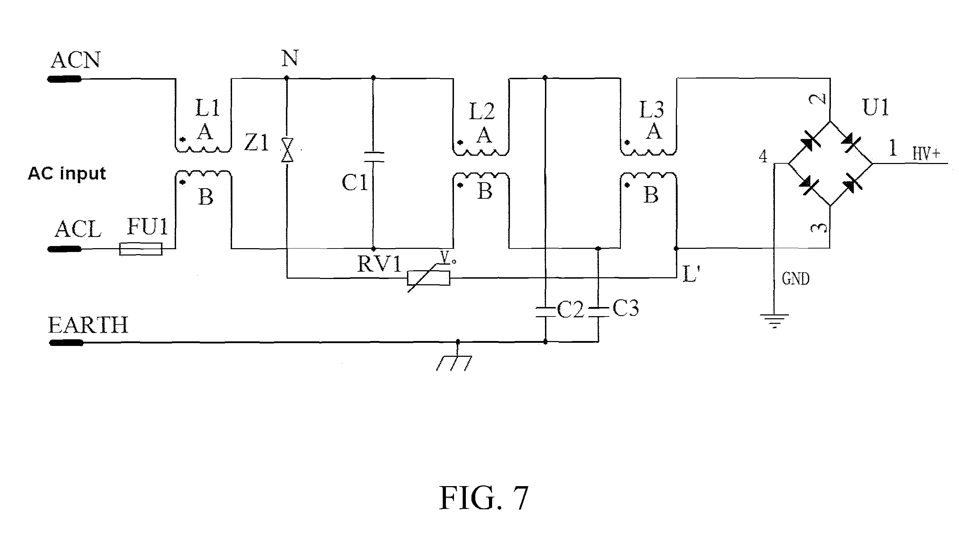

FIG. 7 is a circuit diagram after connection sequences of the piezoresistor and the gas discharge tube are exchanged, and has working principles the same as those in FIG. 6. Hereinafter, working principles of the surge protection circuit are described by using FIG. 6 as an example. When a peak voltage of a surge signal is greater than 470 V, the gas discharge tube Z1 is broken down instantaneously. At this time, the half inductors L2B and L3B of the CM inductors are serially connected to the piezoresistor RV1 and the gas discharge tube Z1 to form a loop. The differential signal passes through the L2B and L3B of the CM inductors. Based on inductive reactance of the inductors and current characteristics, voltage division of the piezoresistor and the gas discharge tube is realized, thereby effectively suppressing sudden change of current in the circuit, and reducing the voltage and surge current applied to the piezoresistor RV1 and the gas discharge tube Z1. After the overvoltage surge disappears, when an alternating current (AC) power supply voltage exceeds a zero point, the surge protection circuit is isolated from other circuits, and the circuit recovers to a normal working state. In this embodiment, because the surge protection circuit only has two stages of DM inductors, an anti-surge effect thereof is poorer than that of the second embodiment. Definitely, the surge protection circuit may also only include one stage of DM inductor. For example, the N point in the third embodiment is disposed at an input end of the inductor L3A, and only the half inductor L3B is connected to the surge protection circuit, so that an anti-surge effect thereof is further poorer. It can be seen that, the anti-surge effect of the surge protection circuit is proportional to the number of serially connected half inductors, that is, a larger number of serially connected half inductors results in a better anti-surge effect.

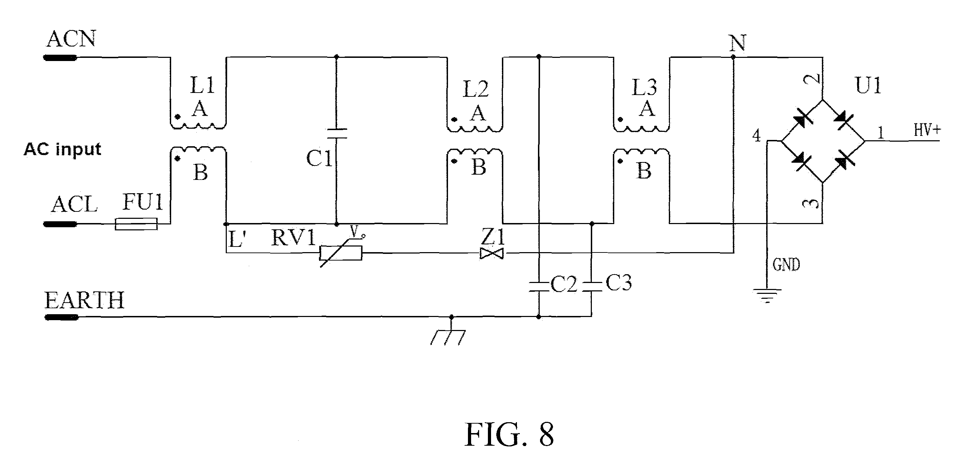

It should be noted that, the positions of the points N and L' may be exchanged, and therefore, various variations are included in the second embodiment and the third embodiment. For example, in the above embodiment, the half inductor B of the CM inductor is used, and the half inductors L2A and L3A (see FIG. 8) may also be used. Definitely, a half inductor A of only one stage CM inductor is connected, or half inductors A of three stages of CM inductors are connected, which is not repeated herein. However, the embodiments of the present invention should meet one condition that the surge protection circuit is serially connected to a half inductor, serving as a DM inductor, of at least one stage of CM inductor.

It can be seen from the third embodiment that, the surge protection circuit may adjust the number of the serially connected DM inductors. In the embodiments of the present invention, the EMI filter circuit preferably uses three stages of CM inductors. Therefore, the number of stages of the CM inductors included in the EMI filter circuit may be adjusted appropriately according to actual requirements. By using FIG. 8 as an example, the EMI filter circuit includes three stages of CM inductors that are serially connected, an X capacitor C1 connected in parallel between two input ends of the CM inductor, and a Y capacitor C2 and a Y capacitor C3 that are respectively connected to two input ends of the CM inductor. At the position of the first-stage CM inductor, 0, 1 ... N CM inductors may be serially connected; at the position of the second-stage CM inductor, 1, 2 ... M CM inductors may be serially connected; and at the position of the third-stage CM inductor, 0, 1, 2 ... L CM inductors may be serially connected. Therefore, when the number of stages of the included CM inductors is large, there are many manners for connecting two ends N and L' of a series circuit formed by the piezoresistor and the gas discharge tube, which are not repeated herein. However, it should be noted that, the surge protection circuit is serially connected to a half inductor, serving as a DM inductor, of at least one stage of CM inductor. A larger number of DM inductors included in the series circuit formed by the piezoresistor and the gas discharge tube results in better surge protection performance.

In addition to the surge protection circuit, the present invention further provides an LED driving power supply. The LED driving power supply is characterized by using the surge protection circuit. Moreover, other components of the LED driving power supply may be implemented by using the prior art, and are not repeated herein.

The surge protection circuit provided in the present invention utilizes two characteristics of the DM inductor: one is that inductive current cannot change suddenly, and the other is that the inductive reactance can be used for voltage division. For a transient surge shock, the DM inductor may effectively avoid the piezoresistor and the gas discharge tube from being damaged due to overvoltage and overcurrent. Moreover, the present invention implements combination of the conventional EMI filter circuit and the surge protection circuit. The surge protection circuit may fully utilize a half inductor winding of the CM inductor to serve as the DM inductor, thereby reducing the cost and volume of a related electronic product. The present invention can effectively suppress the EMI, and enables a related electronic product to be used in a long term during surge shock by using the half inductor of the EMI filter circuit, thereby effectively prolonging the service life of the switching power supply.

The surge protection circuit provided in the present invention is described in detail in the foregoing. For persons of ordinary skill in the art, any obvious modification on the present invention without departing from the essential spirit of the present invention constitutes invasion of the patent right of the present invention, and should bear corresponding legal liability.

## Claims

1. A surge protection circuit, wherein the surge protection circuit is formed by serially connecting a piezoresistor, a discharge tube and a differential mode (DM) inductor.

2. The surge protection circuit according to claim 1, wherein:
the surge protection circuit is connected in parallel between alternating current (AC) input ends.

3. The surge protection circuit according to claim 1, wherein:
one AC input end or two AC input ends are serially connected to the DM inductor; and
a series circuit formed by the piezoresistor and the discharge tube is connected in parallel between AC output ends.

4. The surge protection circuit according to claim 1, wherein:
the DM inductor is implemented by a half inductor of a common mode (CM) inductor in an electromagnetic interference (EMI) filter circuit.

5. The surge protection circuit according to claim 4, wherein:
when the EMI filter circuit includes multiple stages of CM inductors, the DM inductor is a half inductor of a part or all of the CM inductors.

6. The surge protection circuit according to claim 5, wherein:
the EMI filter circuit has three stages of CM inductors, wherein two input ends of a first-stage CM inductor are respectively connected to a neutral wire and a live wire, and two output ends thereof are respectively connected to two input ends of a second-stage CM inductor; two output ends of the second-stage CM inductor are respectively connected to two input ends of a third-stage CM inductor, and an output end of the third-stage CM inductor is connected to a rectifier circuit.

7. The surge protection circuit according to claim 6, wherein:
in a series circuit formed by the piezoresistor and the discharge tube, one end is connected to an input end of one half inductor in the first-stage CM inductor, and the other end is connected to an output end of the other half inductor in the third-stage CM inductor.

8. The surge protection circuit according to claim 6, wherein:
in a series circuit formed by the piezoresistor and the discharge tube, one end is connected to an output end of one half inductor in the first-stage CM inductor, and the other end is connected to an output end of the other half inductor in the third-stage CM inductor.

9. The surge protection circuit according to claim 6, wherein:
in a series circuit formed by the piezoresistor and the discharge tube, one end is connected to an input end of one half inductor in the first-stage CM inductor, and the other end is connected to an output end of the other half inductor in the second-stage CM inductor.

10. The surge protection circuit according to claim 6, wherein:
in a series circuit formed by the piezoresistor and the discharge tube, one end is connected to an input end of one half inductor in a stage CM inductor, and the other end is connected to an output end of the other half inductor in the stage CM inductor.

11. The surge protection circuit according to claim 6, wherein:
a first capacitor is connected in parallel between two input ends of the second-stage CM inductor, and two output ends of the second-stage CM inductor are connected to a ground wire respectively through a second capacitor and a third capacitor.

12. The surge protection circuit according to claim 1, wherein:
the discharge tube is a gas discharge tube.

13. The surge protection circuit according to claim 1, wherein:
the discharge tube is replaced by a short-circuit wire.

14. A light-emitting diode (LED) driving power supply, wherein the LED driving power supply uses the surge protection circuit according to claim 1.
